# EUROPEAN PATENT APPLICATION

(11) **EP 4 742 855 A1**
(43) Date of publication of application: **13.05.2026**
(21) Application number: 24881741.3
(22) Date of filing: 25.10.2024
(51) Int. Cl.: H10D 30/40, H10D 30/47, H10D 62/10

(54) **EPITAXIAL WAFER, RADIO FREQUENCY DEVICE, TERMINAL RADIO FREQUENCY MODULE, AND TERMINAL DEVICE**

(30) Priority: 28.10.2023 CN 202311422361
(71) Applicant: Huawei Technologies Co., Ltd., Shenzhen, Guangdong 518129 (CN)
(72) Inventor: MA, Cheng, Shenzhen, Guangdong 518129 (CN); ZHENG, Dingheng, Shenzhen, Guangdong 518129 (CN); ZHANG, Yawen, Shenzhen, Guangdong 518129 (CN); SU, Shuai, Shenzhen, Guangdong 518129 (CN); WEI, Wei, Shenzhen, Guangdong 518129 (CN); HOU, Mingchen, Shenzhen, Guangdong 518129 (CN); WU, Long, Shenzhen, Guangdong 518129 (CN); TANG, Yongjun, Shenzhen, Guangdong 518129 (CN); FENG, Peng, Shenzhen, Guangdong 518129 (CN); HAN, Mingtao, Shenzhen, Guangdong 518129 (CN)
(74) Representative: Pfenning, Meinig & Partner mbB
(86) International application number: PCT/CN2024/127349
(87) International publication number: WO 2025/087381

(57) **Abstract**

Embodiments of this application provide an epitaxial wafer (100), a radio frequency device (1), a terminal radio frequency module, a terminal device. For the epitaxial wafer (100), the epitaxial wafer (100) includes a silicon substrate layer (10) and an epitaxial layer (20) that are stacked. The epitaxial layer (20) further includes a nucleation layer (201) that is stacked on a surface of the silicon substrate layer (10). In addition, air gaps are provided at an interface between the silicon substrate layer (10) and the nucleation layer (201). The epitaxial wafer (100) may be configured to provide a radio frequency device with a low radio frequency loss based on a special structure and a parameter design at the interface between the silicon substrate layer (10) and the nucleation layer (201) of the epitaxial wafer (100).

## Description

This application claims priority to Chinese Patent Application No. 202311422361.0, filed with the China National Intellectual Property Administration on October 28, 2023 and entitled "EPITAXIAL WAFER, RADIO FREQUENCY DEVICE, TERMINAL RADIO FREQUENCY MODULE, AND TERMINAL DEVICE", which is incorporated herein by reference in its entirety.

### TECHNICAL FIELD

Embodiments of this application relate to the field of semiconductor technologies, and specifically, to an epitaxial wafer, a radio frequency device, a terminal radio frequency module, and a terminal device.

### BACKGROUND

Currently, most radio frequency devices use group III nitride semiconductor devices represented by gallium nitride (GaN), especially a GaN-based radio frequency device that is of a heterostructure and that is based on a silicon carbide substrate. Theoretically, the structure may also be grown on a silicon substrate, and the silicon substrate may be configured to prepare a large-size and low-cost radio frequency device. However, using the silicon substrate may cause a severe radio frequency loss in the radio frequency device, and reduces working efficiency of the radio frequency device.

To reduce a severe radio frequency loss caused by silicon substrate conductivity in a GaN-based radio frequency integrated circuit device on the silicon substrate, a silicon wafer with a high resistivity is usually used as the silicon substrate in the industry, but improvement effect is limited. This is largely due to that a parasitic conductive channel exists at an interface between the silicon substrate and a GaN-based epitaxial structure. In view of this, a person skilled in the art attempts to remove portions of the silicon substrates to eliminate the parasitic conductive channel at the interface between the silicon substrate and the epitaxial structure. However, such an operation is difficult in a process, and also affects structural stability of the radio frequency device, and is also not conductive to promoting and applying the GaN-based radio frequency integrated circuit device. Therefore, there is an urgent need to provide a new epitaxial wafer that can reduce the radio frequency loss of the silicon substrate and ensure structural stability and quality of the epitaxial structure and the radio frequency device.

### SUMMARY

In view of this, embodiments of this application provide an epitaxial wafer, a radio frequency device, a terminal radio frequency module, and a terminal device. The epitaxial wafer may be configured to provide a radio frequency device with a low radio frequency loss based on a special structure and a parameter design at an interface between a silicon substrate layer and a nucleation layer of the epitaxial wafer.

A first aspect of embodiments of this application provides an epitaxial wafer, including a silicon substrate layer and an epitaxial layer that are stacked. The epitaxial layer includes a nucleation layer stacked on a surface of the silicon substrate.

A surface that is of the silicon substrate layer and that is close to the nucleation layer has a plurality of first blind holes, and a surface that is of the nucleation layer and that is close to the silicon substrate layer has a plurality of second blind holes. Any one of the second blind holes is provided corresponding to one first blind hole, and an orthographic projection of the second blind hole on the silicon substrate layer overlaps the corresponding first blind hole.

A depth of the first blind hole is greater than or equal to 200 nm.

According to the foregoing special structure design, there may be a plurality of "air gaps" at an interface between the silicon substrate layer and the nucleation layer. In addition, a depth of the "air gap" at the silicon substrate layer is greater than or equal to 200 nm, and a parasitic conductive channel at the interface between the silicon substrate layer and the nucleation layer can be effectively cut off. This can better suppress parasitic conductivity effect at the interface. Further, the epitaxial wafer can be configured to provide a radio frequency device with a low radio frequency loss.

In some implementations of this application, the depth of the first blind hole is from 200 nm to 500 nm. Controlling the depth of the first blind hole to be within the foregoing range allows the air gaps formed by the first blind holes to fully exert effect of cutting off the parasitic conductive channel between the silicon substrate layer and the nucleation layer, and can also ensure that the silicon substrate layer has a strong support force for a superimposed structure on a surface of the silicon substrate layer. In this way, the epitaxial wafer is easy to prepare, and crystal quality of the epitaxial layer is high. When the epitaxial wafer is applied to the radio frequency device, this is more conductive to improving a power and efficiency of a radio frequency device.

In some implementations of this application, a quantity of the second blind holes is the same as a quantity of the first blind holes, and the plurality of first blind holes are provided in a one-to-one correspondence with the plurality of second blind holes. The epitaxial wafer of the foregoing structure is easy to prepare, and has good effect of suppressing the radio frequency loss.

In some implementations of this application, a depth of the second blind hole is from 300 nm to 500 nm. Controlling the depth of the second blind hole to be within the foregoing range helps ensure that the nucleation layer has good structure strength and mechanical properties, and also helps the air gaps implement good parasitic conductivity suppression effect.

In some implementations of this application, an inner diameter of the first blind hole is equal everywhere in a stacking direction of the silicon substrate layer and the epitaxial layer. In this way, in a region from a plane on which an end face of the first blind holes is located to a surface that is of the silicon substrate layer and that is away from the nucleation layer, structural uniformity of the silicon substrate layer is good, and the parasitic conductive channel can be better cut off. This achieves better benefits of the air gaps formed by the first blind holes, and is more conductive to reducing the radio frequency loss of a final radio frequency device.

In some implementations of this application, an included angle between a side wall of the first blind hole and the surface that is of the silicon substrate layer and that is close to the nucleation layer is from 85° to 90°. In this way, the inner diameter of the first blind hole slightly changes or is equal in a stacking direction of the silicon substrate layer and the nucleation layer. This can avoid a phenomenon that the parasitic conductive channel is not completely disrupted due to structural unevenness of the first blind hole, which affects the benefits of the air gaps.

In some implementations of this application, an opening diameter of the first blind hole is from 100 nm to 1000 nm. Controlling the opening diameter of the first blind hole to be within the foregoing range makes preparation easy, and more importantly, can achieve ideal effect of cutting off the parasitic conductive channel.

In some implementations of this application, an opening shape of the first blind hole is a circle or an n-sided polygon, and n>8. This achieves good benefits of the air gaps formed by the first blind holes, and when the epitaxial wafer is applied to the radio frequency device, this helps suppress the radio frequency loss.

In some implementations of this application, the plurality of first blind holes are periodically arranged in a first direction, and the first direction is perpendicular to a stacking direction of the silicon substrate layer and the nucleation layer. This is to ensure the structural uniformity of the silicon substrate layer, and minimize a risk of a crack occurring in a subsequent application process due to uneven stress distribution or insufficient load-bearing capacity inside the silicon substrate layer. In addition, there may be many repeat units (a region in which a gate, and a drain and a source that are respectively disposed on two sides of the gate are located is considered as a same repeat unit) or circuit elements in the radio frequency device, and in consideration of this, this is to well cut off the parasitic conductive channel in different regions at a first interface in the subsequent application process, which can better suppress the radio frequency loss of the radio frequency device.

In some implementations of this application, in the first direction, a minimum distance between openings of two adjacent first blind holes on the silicon substrate layer is from 200 nm to 1000 nm. Controlling an arrangement pitch of the first blind holes to be within the range also controls a distribution density of the first blind holes. When the epitaxial wafer is applied to the radio frequency device, this helps implement that any repeat unit may have the air gap for suppressing the radio frequency loss, which improves performance of the radio frequency device.

In some implementations of this application, the plurality of first blind holes are periodically arranged in a regular hexagon in the first direction. The first blind holes are periodically arranged in the regular hexagon, which facilitates subsequent growth of the epitaxial layer, and also helps ensure high crystal quality of the epitaxial layer. When the epitaxial wafer is applied to the radio frequency device, this is conductive to improving the power and efficiency of the radio frequency device.

In some implementations of this application, the nucleation layer is a two-dimensional nucleation layer. Crystal quality of the two-dimensional nucleation layer is high. When the epitaxial wafer is applied to the radio frequency device, this can improve the power and efficiency of the radio frequency device, greatly improve device performance, and increase market competitiveness of the radio frequency device.

In some implementations of this application, a thickness of the nucleation layer is from 300 nm to 1000 nm. In this way, the nucleation layer has high structure integrity and high crystal quality, which is more conducive to ensuring improvement of overall crystal quality of the epitaxial layer. In addition, a proper thickness can avoid a risk of cracking on the nucleation layer, thereby improving comprehensive performance of the epitaxial wafer.

In some implementations of this application, the nucleation layer includes a two-dimensional nucleation layer and a three-dimensional nucleation layer that are sequentially stacked, and the two-dimensional nucleation layer is disposed close to the silicon substrate layer. In this way, both crystal quality and production efficiency of the epitaxial layer can be considered, which can improve cost-effectiveness of the epitaxial layer.

In some implementations of this application, a thickness of the two-dimensional nucleation layer is from 300 nm to 500 nm, and a thickness of the three-dimensional nucleation layer is from 200 nm to 500 nm. This can improve production efficiency of the epitaxial wafer while improving crystal quality of the nucleation layer, and is more conductive to preparing and applying the epitaxial wafer.

In some implementations of this application, the nucleation layer is an aluminum nitride layer. Aluminum nitride has a high band gap (up to 6.2 eV), and features high resistance, high hardness, high chemical stability, a high breakdown electric field, and a low dielectric loss, which can further improve performance of the final radio frequency device.

In some implementations of this application, a dislocation density of the two-dimensional nucleation layer is less than 5×10⁹/cm², and surface roughness of the two-dimensional nucleation layer is less than 0.5 nm. When the two-dimensional nucleation layer meets the foregoing conditions, it indicates that crystal quality of the two-dimensional nucleation layer is high, which can improve the power and efficiency performance of the final radio frequency device.

In some implementations of this application, a molar ratio of a group V element to a group III element on the two-dimensional nucleation layer is 1:(20-100). In this way, the two-dimensional nucleation layer is easily obtained, which is conducive to improving crystal quality of the epitaxial wafer, and is conducive to the power and efficiency of the final radio frequency device.

In some implementations of this application, a molar ratio of a group V element to a group III element on the three-dimensional nucleation layer is 1:(100-2000). In this way, the three-dimensional nucleation layer is easily obtained, which improves production efficiency of the epitaxial wafer.

In some implementations of this application, the epitaxial layer further includes a stress regulation layer, a high-resistance buffer layer, a channel layer, an insertion layer, a barrier layer, and a cap layer that are sequentially stacked. The stress regulation layer is disposed on a surface that is of the nucleation layer and that is away from the silicon substrate layer.

In some implementations of this application, a room-temperature resistivity of the silicon substrate layer is greater than or equal to 2000 Ω·cm. This can reduce a radio frequency loss caused by the silicon substrate layer, and is also conductive to improving performance of the final radio frequency device.

A second aspect of embodiments of this application provides a preparation method for an epitaxial wafer, including:
providing a silicon substrate, and forming the plurality of first blind holes on one side surface of the silicon substrate to obtain the silicon substrate layer; and
growing the epitaxial layer on the surface that is of the silicon substrate layer and that has the first blind holes, where the epitaxial layer includes the nucleation layer.

The preparation method has simple steps, strong process controllability, and high production efficiency, and is applicable to large-scale industrial production.

In some implementations of this application, the two-dimensional nucleation layer is grown on the surface that is of the silicon substrate layer and that has the first blind holes. A growth temperature of the two-dimensional nucleation layer is from 1000°C to 1200°C, a growth pressure is from 50 mbar to 100 mbar, and a molar ratio of a group V element to a group III element in a growth raw material is 1:(20-100). In this way, atoms can be induced to laterally migrate, which induces the atoms to laterally grow. This facilitates preparation of the two-dimensional nucleation layer, reduces a density of a nucleation island of the two-dimensional nucleation layer, and increases a size of the nucleation island, thereby reducing a dislocation density introduced by inter-island coalescence at an early stage of growth of the two-dimensional nucleation layer, and helping improve crystal quality of the two-dimensional nucleation layer.

In some implementations of this application, the method further includes: growing the three-dimensional nucleation layer on a side surface that is of the two-dimensional nucleation layer and that is away from the silicon substrate layer. A growth temperature of the three-dimensional nucleation layer is from 900°C to 1100°C, a growth pressure is from 100 mbar to 300 mbar, and a molar ratio of a group V element to a group III element in a growth raw material is 1:(100-2000). In this way, the atoms can be induced to both laterally and vertically grow, which improves a growth rate of the nucleation layer, and further improves production efficiency of the epitaxial wafer.

A third aspect of embodiments of this application provides a radio frequency device, including a drain, a source, a gate, and the epitaxial wafer according to the first aspect of embodiments of this application. The drain, the source, and the gate are disposed on a surface that is of the epitaxial layer and that is away from the silicon substrate layer, and the drain and the source are respectively disposed on two opposite sides of the gate and are isolated from each other.

By adopting the epitaxial wafer provided in embodiments of this application, the radio frequency device has a low radio frequency loss, low production costs, and can be prepared into a large size.

In some implementations of this application, the radio frequency device is a power amplifier.

A fourth aspect of embodiments of this application provides a terminal radio frequency module, including the radio frequency device provided in the third aspect of embodiments of this application and an antenna. The radio frequency device is configured to amplify a radio frequency signal and output an amplified radio frequency signal to the antenna for radiation to the outside.

The terminal radio frequency module can have a high power, high efficiency, and a low radio frequency loss, and therefore have strong market competitiveness.

A fifth aspect of embodiments of this application provides a terminal device, including the terminal radio frequency module provided in the fourth aspect of embodiments of this application. The terminal device has a promising market prospect.

### BRIEF DESCRIPTION OF DRAWINGS

FIG. 1A is a top view of a silicon substrate layer according to an embodiment of this application;
FIG. 1B is a diagram of a structure of a cross section of a silicon substrate layer according to an embodiment of this application;
FIG. 2 is a diagram of a structure of a cross section of a silicon substrate layer and a nucleation layer of an epitaxial wafer according to an embodiment of this application;
FIG. 3 is a diagram of a structure of a cross section of a silicon substrate layer and a nucleation layer of an epitaxial wafer according to another embodiment of this application;
FIG. 4 is a diagram of a structure of a cross section of an epitaxial wafer according to an embodiment of this application;
FIG. 5 is a diagram of a structure of a cross section of an epitaxial wafer according to another embodiment of this application;
FIG. 6 is a diagram of a structure of a radio frequency device according to an embodiment of this application; and
FIG. 7 is a flowchart of a process of preparing a radio frequency device according to an embodiment of this application.

Reference numerals: 100: epitaxial wafer; 10: silicon substrate layer; 20: epitaxial layer; 201: nucleation layer; 201a: two-dimensional nucleation layer; 201b: three-dimensional nucleation layer; 202: stress regulation layer; 203: high-resistance buffer layer; 204: channel layer; 205: insertion layer; 206: barrier layer; 207: cap layer; 1: radio frequency device; 2: drain; 3: source; 4: gate; 5: interconnect metal; 6: passivation layer.

### DESCRIPTION OF EMBODIMENTS

In a semiconductor industry chain, especially in a third-generation semiconductor industry chain, a radio frequency device usually includes an epitaxial wafer and a structure disposed on the epitaxial wafer. The epitaxial wafer includes a substrate layer and an epitaxial layer. If materials of the substrate layer and the epitaxial layer are different, the radio frequency device is of a heterostructure. An epitaxial wafer whose epitaxial layer uses group III nitride such as gallium nitride (GaN) makes the radio frequency device achieve excellent performance such as a high band gap, a high breakdown electric field, a high saturated electron drift velocity, and strong polarization effect. In particular, a radio frequency device with a GaN-based epitaxial wafer that uses silicon or silicon carbide as a substrate also has excellent characteristics such as a high power density and applicability at a high frequency. Currently, a commercialized GaN-based radio frequency device usually uses an expensive silicon carbide substrate, which is mainly due to a severe radio frequency loss of a GaN-on-silicon radio frequency device. However, due to a mature production technology, high quality, and a large size, a silicon wafer may be used to prepare a larger-size epitaxial wafer. Moreover, costs of the silicon wafer are low. Coupled with a remaining capacity of wafer foundries, the GaN-on-silicon radio frequency device may achieve an absolute cost advantage. Furthermore, due to a mature silicon-based large-scale integrated circuit production process, the GaN-on-silicon radio frequency device also has a good potential for preparation. Therefore, it is particularly important to resolve the radio frequency loss problem of the GaN-on-silicon radio frequency device, and is also a key to promoting large-scale application of a low-cost GaN-based radio frequency device.

The industry tries to use a high-resistance silicon substrate to resolve the preceding problem, but improvement effect is limited. The cause may be: Strong polarization effect of the group III nitride causes an electron channel at an interface between a silicon substrate and an upper-layer structure, and parasitic conductivity is formed. Consequently, a large radio frequency loss occurs when the radio frequency device works.

To resolve the foregoing technical problem, an embodiment of this application provides an epitaxial wafer, including a silicon substrate layer and an epitaxial layer that are stacked. The epitaxial layer includes a nucleation layer that is stacked on a surface of the silicon substrate. A surface that is of the silicon substrate layer and that is close to the nucleation layer has a plurality of first blind holes 101, and a surface that is of the nucleation layer and that is close to the silicon substrate layer has a plurality of second blind holes 210. Any one of the second blind holes 210 is provided corresponding to one first blind hole 101, and an orthographic projection of the second blind hole 210 on the silicon substrate layer overlaps the corresponding first blind hole 101. A depth of the first blind hole 101 is greater than or equal to 200 nm. In this embodiment of this application, a scanning electron microscope (scanning electron microscope, SEM) may be used to observe a cross section of a slice of the epitaxial wafer to represent existence and parameters of the first blind hole 101 and the second blind hole 210. The depth of the first blind hole 101 is a size of the first blind hole 101 in a stacking direction of the silicon substrate layer and the nucleation layer.

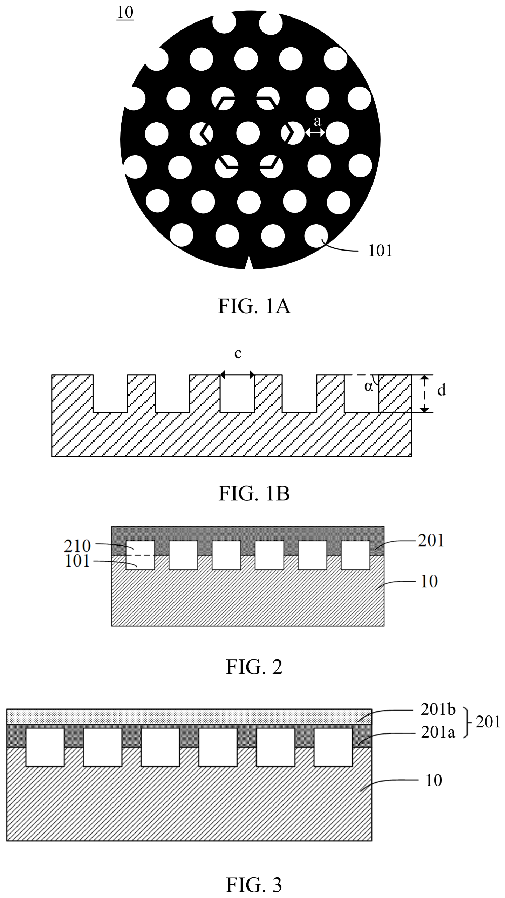

With reference to FIG. 1A to FIG. 5, an epitaxial wafer 100 includes a silicon substrate layer 10 and an epitaxial layer 20 that are stacked. The epitaxial layer 20 includes a nucleation layer 201 that is stacked on a surface of the silicon substrate layer 10. A surface that is of the silicon substrate layer 10 and that is close to the nucleation layer 201 has a plurality of first blind holes 101, and a surface that is of the nucleation layer 201 and that is close to the silicon substrate layer 10 has a plurality of second blind holes 210. Any one of the second blind holes 210 is provided corresponding to one first blind hole 101. One group of the first blind hole 101 and the second blind hole 210 that are correspondingly disposed is used as an example, and an orthographic projection of the second blind hole 210 on the silicon substrate layer 10 overlaps the first blind hole 101. In this case, an interface between the silicon substrate layer 10 and the nucleation layer 201 has "air gaps" jointly formed by the first blind holes 101 and the second blind holes 210. The air gaps extend from the inside of the silicon substrate layer 10 to the inside of the nucleation layer 201. A triangular notch in FIG. 1A is an alignment notch commonly used for the silicon substrate layer on the market.

It may be understood that the silicon substrate layer 10 has a first surface and a second surface that are disposed opposite to each other, and the nucleation layer 201 has a third surface and a fourth surface that are disposed opposite to each other. For ease of description, the first surface is defined as a surface that is of the silicon substrate layer 10 and that is close to the nucleation layer 201, the third surface is defined as a surface that is of the nucleation layer 201 and that is close to the silicon substrate layer 10, and the interface between the silicon substrate layer 10 and the nucleation layer 201 is defined as the "first interface". It may be understood that the first interface is also the interface between the silicon substrate layer 10 and the epitaxial layer 20 in essence. A first direction is defined, where the first direction is perpendicular to a stacking direction of the silicon substrate layer 10 and the epitaxial layer 20. A second direction is defined, where the second direction is the stacking direction of the silicon substrate layer 10 and the epitaxial layer 20.

In this embodiment of this application, the nucleation layer 201 completely covers the first surface of the silicon substrate layer 10.

According to the foregoing special structure design, there may be a plurality of "air gaps" at the interface between the silicon substrate layer 10 and the nucleation layer 201. In addition, a depth of the "air gap" at the silicon substrate layer 10 is greater than or equal to 200 nm (that is, a depth d of the first blind hole 101 is greater than or equal to 200 nm), and a parasitic conductive channel at a first interface can be effectively cut off. This can better suppress parasitic conductivity effect at the first interface. Further, the epitaxial wafer 100 may be configured to provide a radio frequency device with a low radio frequency loss. If the depth of the air gap on the silicon substrate layer 10 is excessively small, a continuous parasitic conductive layer is still formed at the interface between the silicon substrate layer 10 and the epitaxial layer 20, and there is high-concentration hole conductivity. As a result, the air gaps cannot smoothly achieve effect of cutting off the parasitic conductive channel, and almost cannot suppress the radio frequency loss. Specifically, the depth of the first blind hole 101 (the depth of the air gap on the silicon substrate layer 10) may be but is not limited to 200 nm, 220 nm, 250 nm, 280 nm, 300 nm, 320 nm, 350 nm, 380 nm, 400 nm, 420 nm, 450 nm, 480 nm, 500 nm, 520 nm, 550 nm, or the like.

In some implementations of this application, the depth (d) of the first blind hole 101 is from 200 nm to 500 nm. In other words, the depth of the air gap on the silicon substrate layer 10 is from 200 nm to 500 nm. Controlling the depth of the first blind hole 101 to be within the foregoing range allows the air gaps formed by the first blind holes 101 to fully exert effect of cutting off the parasitic conductive channel at the first interface, and can also ensure that the silicon substrate layer 10 has a strong support force for a superimposed structure on a surface of the silicon substrate layer 10. In this way, the epitaxial wafer 100 is easy to prepare, and crystal quality of the epitaxial layer 20 is high. When the epitaxial wafer 100 is applied to the radio frequency device. This is more conductive to improving a power and efficiency of a radio frequency device. Specifically, the depth (d) of the first blind hole 101 may be but is not limited to 200 nm, 210 nm, 240 nm, 260 nm, 290 nm, 310 nm, 340 nm, 390 nm, 410 nm, 430 nm, 440 nm, 460 nm, 490 nm, 500 nm, or the like.

In some implementations, the second blind hole 210 is brought by a preparation process used by the epitaxial wafer 100. Specifically, the nucleation layer 201 is directly grown and obtained on the surface that is of the silicon substrate layer 10 and that has the plurality of first blind holes 101. However, atoms have difficulty settling on a non-close-packed crystal plane (a first blind hole region), and the atoms settle on a close-packed crystal plane (a non-first blind hole region) to grow a material of the nucleation layer 201. In addition, the material grown on the surface of the non-first blind hole region may gradually coalesce, to form the second blind hole 210. In consideration of this, in some specific embodiments, a quantity of the second blind holes 210 is the same as a quantity of the first blind holes 101, and the plurality of first blind holes 101 are provided in a one-to-one correspondence with the second blind holes 210.

In some implementations of this application, a depth of the second blind hole 210 is from 300 nm to 500 nm. It may be understood that in some cases, another functional layer is further superimposed on a surface that is of the nucleation layer 201 and that is away from the silicon substrate layer 10. Controlling the depth of the second blind hole 210 to be within the foregoing range can ensure that the nucleation layer 201 has good structural strength and mechanical properties, provide a good support force for a subsequent upper-layer structure, and also help the air gaps implement good parasitic conductivity suppression effect. Specifically, the depth of the second blind hole 210 may be but is not limited to 300 nm, 320 nm, 350 nm, 380 nm, 400 nm, 420 nm, 450 nm, 480 nm, 500 nm, or the like. In this case, a total depth of the air gap in the stacking direction of the silicon substrate layer 10 and the epitaxial layer 20 is from 500 nm to 1000 nm. Specifically, the total depth of the air gap in the stacking direction of the silicon substrate layer 10 and the epitaxial layer 20 may be but is not limited to 500 nm, 520 nm, 550 nm, 580 nm, 600 nm, 620 nm, 650 nm, 680 nm, 700 nm, 720 nm, 750 nm, 780 nm, 800 nm, 820 nm, 850 nm, 880 nm, 900 nm, 920 nm, 950 nm, 980 nm, 1000 nm, or the like. A person skilled in the art may make a selection based on an actual production requirement.

In some implementations of this application, an opening shape of the first blind hole 101 is a circle or an n-sided polygon, and n>8. It may be understood that n is a positive integer. This achieves good benefits of the air gaps formed by the first blind holes 101, and when the epitaxial wafer 100 is applied to the radio frequency device this helps suppress the radio frequency loss. Specifically, the opening shape of the first blind hole 101 may be a nonagon, a decagon, a hendecagon, a dodecagon, a tetradecagon, a pentadecagon, a heptadecagon, an octadecagon, an icosagon, or the like. In some specific embodiments of this application, the opening shape of the first blind hole 101 is preferably a circle. This is more conductive to suppressing the radio frequency loss of the radio frequency device.

In some implementations of this application, an inner diameter of the first blind hole 101 is equal everywhere in the stacking direction of the silicon substrate layer 10 and the epitaxial layer 20. In this way, in a region between a plane on which an end face of the plurality of first blind holes 101 is located and the first surface, structural uniformity of the silicon substrate layer 10 is good, and the parasitic conductive channel can be better cut off. This achieves better benefits of the air gaps formed by the first blind holes 101, and is more conductive to reducing the radio frequency loss of a final radio frequency device. In this case, in some specific embodiments, a side wall of the first blind hole 101 is perpendicular to the first surface. However, in consideration of process precision and preparation difficulty, in some other implementations, the inner diameter of the first blind hole 101 gradually increases or decreases in the stacking direction of the silicon substrate layer 10 and the epitaxial layer 20. In this case, an inclination angle exists between the side wall of the first blind hole 101 and the first surface.

In some implementations of this application, with reference to FIG. 1B, an included angle (α) between the side wall of the first blind hole 101 and the first surface is from 85° to 90°. In some specific embodiments, the included angle is 90°, and the side wall of the first blind hole 101 is perpendicular to the first surface. In this case, structural uniformity of the first blind hole 101 is good, which helps improve benefits of the air gaps and better cut off the parasitic conductive channel at the first interface. When the included angle is greater than or equal to 85° and less than 90°, a small inclination angle exists between the side wall of the first blind hole 101 and the first surface. The depth of the first blind hole 101 is greater than or equal to 200 nm, and therefore the inner diameter of the first blind hole 101 slightly changes in the second direction. This can avoid a phenomenon that the parasitic conductive channel is not completely disrupted due to structural unevenness of the first blind hole 101, which affects the benefits of the air gaps.

To improve the benefits of the air gaps and better suppress the parasitic conductivity effect at the first interface, in some implementations of this application, an opening diameter of the first blind hole 101 is from 100 nm to 1000 nm. Controlling the opening diameter of the first blind hole 101 to be within the foregoing range makes preparation easy, and more importantly, can achieve ideal effect of cutting off the parasitic conductive channel. During preparation of the epitaxial wafer 100, parameters of the first blind hole 101 are all inherited from a structure of the silicon substrate layer 10. However, at least in some situations, the nucleation layer 201 is gradually grown on the first surface of the silicon substrate layer 10, and the opening diameter of the first blind hole 101 may also affect a parameter (for example, the depth) of the second blind hole 210 and crystal quality of the nucleation layer 201. In this case, controlling the opening diameter of the first blind hole 101 to be within the foregoing range can ensure that the subsequently grown nucleation layer 201 is easy to coalesce and achieve high crystal quality. Specifically, the opening diameter of the first blind hole 101 may be but is not limited to 100 nm, 150 nm, 200 nm, 250 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1000 nm, or the like. In this embodiment of this application, the opening diameter of the first blind hole 101 may be tested by using the SEM. When the opening shape of the first blind hole 101 is a circle, the opening diameter is a diameter of the opening. When the opening shape of the first blind hole 101 is an n-sided polygon, the opening diameter is a diameter of a circumscribed circle of the n-sided polygon.

Based on a preparation technology and a process parameter of the epitaxial wafer 100, at least in some situations, the second blind hole 210 is formed in a growth process of the nucleation layer 201. Therefore, an inner diameter of the second blind hole 210 may gradually decrease in the second direction, or may irregularly change. This is not limited in this application. In some specific embodiments, the inner diameter of the second blind hole 210 changes within a range of 100 nm to 1000 nm in the second direction. Specifically, the inner diameter of the second blind hole 210 may be but is not limited to 100 nm, 150 nm, 200 nm, 250 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1000 nm, or the like.

In some implementations of this application, the plurality of first blind holes 101 are periodically arranged in the first direction. That is, the plurality of first blind holes 101 are periodically arranged on the first surface. This is to ensure the structural uniformity of the silicon substrate layer 10, and minimize a risk of a crack occurring in a subsequent application process due to uneven stress distribution or insufficient load-bearing capacity inside the silicon substrate layer 10. In addition, there may be many repeat units (a region in which a gate, and a drain and a source that are respectively disposed on two sides of the gate are located is considered as a same repeat unit) or circuit elements in the radio frequency device, and in consideration of this, this is to well cut off the parasitic conductive channel in different regions at the first interface in the subsequent application process, which can better suppress the radio frequency loss of the radio frequency device. It may be understood that the plurality of second blind holes 210 one-to-one correspond to the plurality of first blind holes 101. In this case, the plurality of second blind holes 210 are periodically arranged on the third surface. In other words, the air gaps jointly formed by the first blind holes 101 and the second blind holes 210 are periodically arranged at the first interface.

In some implementations of this application, the plurality of first blind holes 101 are periodically arranged in a regular hexagon in the first direction. Specifically, periodically arranged in the regular hexagon may be understood as follows: Except for the first blind hole 101 located at an edge of the epitaxial wafer 100, any first blind hole 101 is used as a center, and is surrounded by six first blind holes 101, and connection lines sequentially connecting geometric centers of openings of the six first blind holes 101 on the silicon substrate layer 10 form a regular hexagon. The first blind holes 101 are periodically arranged in the regular hexagon, which facilitates subsequent growth of the epitaxial layer 20, and also helps ensure high crystal quality of the epitaxial layer 20. When the epitaxial wafer is applied to the radio frequency device, this is conductive to improving the power and efficiency of the radio frequency device. It may be understood that in this case, the air gaps jointly formed by the first blind holes 101 and the second blind holes 210 are periodically arranged in a regular hexagon at the first interface.

In some implementations of this application, with reference to FIG. 1A, an arrangement pitch a of the first blind holes 101 is from 200 nm to 1000 nm. Specifically, in the first direction, a minimum distance a between openings of two adjacent first blind holes 101 on the silicon substrate layer 10 is from 200 nm to 1000 nm. Controlling the arrangement pitch of the first blind holes 101 to be within the foregoing range also controls distribution densities of the first blind holes 101 and the air gaps. When the epitaxial wafer is applied to the radio frequency device, this helps implement that any repeat unit may have the air gap for suppressing the radio frequency loss, which improves performance of the radio frequency device. Specifically, the arrangement pitch of the first blind holes 101 may be but is not limited to 200 nm, 250 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1000 nm, or the like. In some specific embodiments, with reference to FIG. 1A, the plurality of first blind holes 101 are periodically arranged in a regular hexagon, and the arrangement pitch a is from 200 nm to 1000 nm. Similarly, the arrangement pitch a of the air gaps formed by the first blind holes 101 and the second blind holes 210 is from 200 nm to 1000 nm.

In this embodiment of this application, a specific material of the nucleation layer 201 may be selected from a group III/V compound available on the GaN-based epitaxial wafer 100. In some specific embodiments, the nucleation layer 201, a two-dimensional nucleation layer 201a, is an aluminum nitride layer.

In some implementations of this application, the nucleation layer 201 is a two-dimensional nucleation layer. Crystal quality of the two-dimensional nucleation layer is high. When the epitaxial wafer 100 is applied to the radio frequency device, this can improve the power and efficiency of the radio frequency device, greatly improve device performance, and increase market competitiveness of the radio frequency device.

In some specific implementations of this application, with reference to FIG. 2, the nucleation layer 201 is the two-dimensional nucleation layer, and a thickness of the nucleation layer 201 is from 300 nm to 1000 nm. In this way, the nucleation layer 201 has high structure integrity and high crystal quality, which is more conducive to ensuring improvement of overall crystal quality of the epitaxial layer 20. In addition, a proper thickness can avoid a risk of cracking on the nucleation layer 201, thereby improving comprehensive performance of the epitaxial wafer 100. Specifically, the thickness of the nucleation layer 201 may be but is not limited to 300 nm, 350 nm, 400 nm, 450 nm, 500 nm, 550 nm, 600 nm, 650 nm, 700 nm, 750 nm, 800 nm, 850 nm, 900 nm, 950 nm, 1000 nm, or the like.

In some implementations of this application, with reference to FIG. 3, the nucleation layer 201 includes the two-dimensional nucleation layer 201a and a three-dimensional nucleation layer 201b that are sequentially stacked, and the two-dimensional nucleation layer 201a is disposed close to the silicon substrate layer 10. The two-dimensional nucleation layer 201a is a nucleation layer 201 that is obtained through atom growth mainly in the first direction, and the three-dimensional nucleation layer 201b is a nucleation layer 201 that is obtained through atom growth in both the first direction and the second direction. The two-dimensional nucleation layer 201a is first grown on the surface of the silicon substrate layer 10. This can reduce a nucleation conductivity density, reduce a dislocation density, and reduce a crystal size to improve crystal quality of the nucleation layer 201, which further improves crystal quality of a structure of another epitaxial layer 20 that subsequently grows on the surface of the nucleation layer 201, and improves performance such as the power and efficiency of the final radio frequency device. Based on the foregoing difference, the two-dimensional nucleation layer 201a has higher crystal quality, and is disposed close to the silicon substrate layer 10, which ensures high quality of the epitaxial wafer 100. A growth rate of the three-dimensional nucleation layer 201b is high. Therefore, in this case, production efficiency of the epitaxial wafer 100 can be improved while quality of the epitaxial wafer 100 is considered.

In some specific embodiments, a thickness of the two-dimensional nucleation layer 201a is from 300 nm to 500 nm, and a thickness of the three-dimensional nucleation layer 201b is from 200 nm to 500 nm. This can improve production efficiency of the epitaxial wafer 100 while improving crystal quality of the nucleation layer 201, and is more conductive to preparing and applying the epitaxial wafer 100. Specifically, in the foregoing case, the thickness of the two-dimensional nucleation layer 201a may be but is not limited to 300 nm, 320 nm, 350 nm, 380 nm, 400 nm, 420 nm, 450 nm, 480 nm, or 500 nm, and the thickness of the three-dimensional nucleation layer 201b may be but is not limited to 200 nm, 220 nm, 250 nm, 280 nm, 300 nm, 320 nm, 350 nm, 380 nm, 400 nm, 420 nm, 450 nm, 480 nm, or 500 nm.

In some specific embodiments, a material of the two-dimensional nucleation layer 201a and that of the three-dimensional nucleation layer 201b are both aluminum nitride. Aluminum nitride has a high band gap (up to 6.2 eV), and features high resistance, high hardness, high chemical stability, a high breakdown electric field, and a low dielectric loss, which can further improve performance of the final radio frequency device.

High crystal quality of the two-dimensional nucleation layer 201a may be specifically reflected in a dislocation density and surface roughness. In some specific embodiments of this application, the dislocation density of the two-dimensional nucleation layer 201a is less than 5×10⁹/cm², for example, from 1.5×10⁹/cm² to 3×10⁹/cm², and the surface roughness of the two-dimensional nucleation layer 201a is less than 0.5 nm, for example, from 0.2 nm to 0.35 nm. The dislocation density is defined as a total length of dislocation lines included in a unit volume of crystal, or a quantity of dislocation lines that pass through a unit cross-sectional area of crystal. Specifically, a method for testing the dislocation density of the two-dimensional nucleation layer 201a includes a transmission electron microscope (Transmission Electron Microscope, TEM), and a method for testing the surface roughness of the two-dimensional nucleation layer 201a includes an atomic force microscope (Atomic Force Microscope, AFM).

In this embodiment of this application, when the second blind hole 210 is provided on the third surface of the nucleation layer 201, and the nucleation layer 201 includes the two-dimensional nucleation layer 201a and the three-dimensional nucleation layer 201b that are stacked, the following situation may be included: The second blind hole 210 penetrates the two-dimensional nucleation layer 201a and extends to the three-dimensional nucleation layer 201b, or the second blind hole 210 does not penetrate the two-dimensional nucleation layer 201a.

In some implementations of this application, a molar ratio of a group V element to a group III element on the two-dimensional nucleation layer 201a is 1:(20-100). For example, when the material of the two-dimensional nucleation layer 201a is AlN, a molar ratio of an N element to an Al element on the two-dimensional nucleation layer 201a is 1:(20-100). In this way, the two-dimensional nucleation layer 201a is easily obtained, which is conducive to improving crystal quality of the epitaxial wafer 100, and is conducive to the power and efficiency of the final radio frequency device. Specifically, on the two-dimensional growth layer, the molar ratio of the group V element to the group III element may be but is not limited to 1:20, 1:30, 1:40, 1:50, 1:60, 1:70, 1:80, 1:90, 1:95, 1:98, or the like.

In some implementations of this application, a molar ratio of a group V element to a group III element on the three-dimensional nucleation layer 201b is 1:(100-2000). For example, when the material of the three-dimensional nucleation layer 201b is AlN, a molar ratio of an N element to an Al element on the three-dimensional nucleation layer 201b is 1:(100-2000). In this way, the three-dimensional nucleation layer 201b is easily obtained, which improves production efficiency of the epitaxial wafer 100. Specifically, the molar ratio of the group V element to the group III element on the three-dimensional nucleation layer 201b may be but is not limited to 1:120, 1:150, 1:180, 1:200, 1:250, 1:300, 1:350, 1:400, 1:500, 1:600, 1:700, 1:800, 1:900, 1:1000, 1:1200, 1:1500, 1:1800, or the like.

In some implementations of this application, a room-temperature resistivity of the silicon substrate layer 10 is greater than or equal to 2000 Ω·cm, for example, is from 3000 Ω·cm to 5000 Ω·cm, or greater than 5000 Ω·cm. This can reduce a radio frequency loss caused by the silicon substrate layer 10, and is also conductive to improving performance of the final radio frequency device.

In this embodiment of this application, a thickness of the silicon substrate layer 10 is not specifically limited, and may be a thickness known in the art. However, it may be understood that because the depth of the first blind hole 101 is greater than or equal to 200 nm, the thickness of the silicon substrate layer 10 is at least greater than 200 nm. For example, the thickness of the silicon substrate layer 10 may be from 100 µm to 1000 µm.

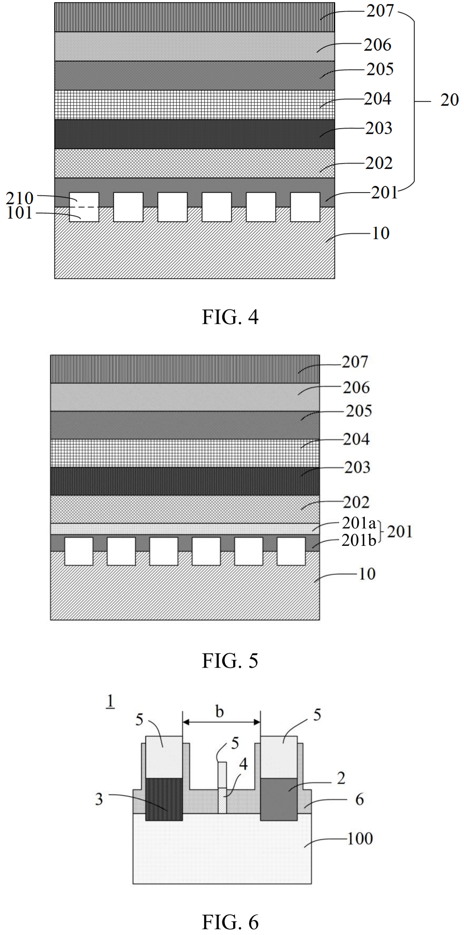

In some implementations of this application, with reference to FIG. 4 and FIG. 5, the epitaxial layer 20 further includes a stress regulation layer 202, a high-resistance buffer layer 203, a channel layer 204, an insertion layer 205, a barrier layer 206, and a cap layer 207 that are sequentially stacked. The stress regulation layer 202 is disposed on a surface that is of the nucleation layer 201 and that is away from the silicon substrate layer 10. In this case, the epitaxial wafer 100 includes the silicon substrate layer 10, the nucleation layer 201 (the nucleation layer 201 is the two-dimensional nucleation layer), the stress regulation layer 202, the high-resistance buffer layer 203, the channel layer 204, the insertion layer 205, the barrier layer 206, and the cap layer 207 that are sequentially stacked, and a plurality of air gaps are periodically arranged at the interface between the silicon substrate layer 10 and the nucleation layer 201. Alternatively, the epitaxial wafer 100 includes the silicon substrate layer 10, the two-dimensional nucleation layer 201a, the three-dimensional nucleation layer 201b, the stress regulation layer 202, the high-resistance buffer layer 203, the channel layer 204, the insertion layer 205, the barrier layer 206, and the cap layer 207 that are sequentially stacked, and a plurality of air gaps are periodically arranged at an interface between the silicon substrate layer 10 and the two-dimensional nucleation layer 201a. The cap layer 207 may be configured to provide ohmic contact.

The stress regulation layer 202 includes but is not limited to a single GaN layer, a single AlGaN layer, an Al-composition step-graded multilayer AlGaN layer, an Al-composition linearly graded AlGaN layer, an AlN/GaN superlattice layer, an AlGaN/GaN superlattice layer, and an A1N/AlGaN superlattice layer. In embodiments of this application, a thickness of the stress regulation layer 202 is not specifically limited, and a person of ordinary skill in the art may adjust the thickness based on an actual application requirement. Specifically, the thickness of the stress regulation layer 202 may be from 50 nm to 1000 nm. In embodiments of this application, thicknesses of the AlN/GaN superlattice layer, the AlGaN/GaN superlattice layer, and a single AlN layer in the AlN/AlGaN superlattice layer, the single GaN layer, and the single AlGaN layer, and a quantity of repetition periods of each of the superlattice layers are not limited.

The high-resistance buffer layer 203 includes but is not limited to an AlGaN layer (Al%<10%) and a GaN layer. In some specific embodiments, when the high-resistance buffer layer 203 includes the AlGaN layer, a molar percent of Al on the AlGaN layer is less than 10%, for example, 1%, 2%, 5%, 6%, or 8%. This can improve resistivity of the AlGaN layer, can also ensure high quality of the AlGaN layer, and can also prevent a parallel channel from being introduced into the epitaxial wafer 100, which helps ensure performance of the final radio frequency device. In embodiments of this application, a thickness of the high-resistance buffer layer 203 is not specifically limited, and a person of ordinary skill in the art may adjust the thickness based on an actual application requirement. Specifically, the thickness of the high-resistance buffer layer 203 may be from 200 nm to 2000 nm.

The channel layer 204 includes but is not limited to a GaN layer. In embodiments of this application, a thickness of the channel layer 204 is not specifically limited, and a person of ordinary skill in the art may adjust the thickness based on an actual application requirement. Specifically, the thickness of the channel layer 204 may be from 150 nm to 400 nm.

The insertion layer 205 includes but is not limited to an AlN layer. In embodiments of this application, a thickness of the insertion layer 205 is not specifically limited, and a person of ordinary skill in the art may adjust the thickness based on an actual application requirement. Specifically, the thickness of the insertion layer 205 may be from 0.5 nm to 1.5 nm.

The barrier layer 206 includes but is not limited to a III-N barrier layer 206, for example, an AlN layer, an AlGaN layer, an InAlN layer, and an InAlGaN layer. In embodiments of this application, a thickness of the barrier layer 206 is not specifically limited, and a person of ordinary skill in the art may adjust the thickness based on an actual application requirement. Specifically, the thickness of the barrier layer 206 may be from 5 nm to 30 nm.

The cap layer 207 includes but is not limited to a GaN layer. In embodiments of this application, a thickness of the cap layer 207 is not specifically limited, and a person of ordinary skill in the art may adjust the thickness based on an actual application requirement. Specifically, the thickness of a GaN cap layer may be from 1 nm to 5 nm.

An embodiment of this application further provides a preparation method for an epitaxial wafer, which may be used to prepare the epitaxial wafer 100, and includes the following steps.

S01: Provide a silicon substrate, and form a plurality of first blind holes on one side surface of the silicon substrate to obtain a silicon substrate layer, where a depth of the first blind hole is greater than or equal to 200 nm.

S02: Grow an epitaxial layer on the surface (that is, the foregoing first surface) that is of the silicon substrate layer and that has the first blind holes, where the epitaxial layer includes a nucleation layer. Atoms basically cannot settle on a non-close-packed crystal plane. Therefore, the first blind hole may be retained on the obtained epitaxial wafer, and the second blind hole is formed in a coalescence process of the nucleation layer. In some specific embodiments, a second blind hole is formed at a corresponding position of any first blind hole.

The preparation method has simple steps, strong process controllability, and high production efficiency, and is applicable to large-scale industrial production.

In some implementations of this application, in step S01, a method for forming the plurality of first blind holes on the first surface includes but is not limited to nanoimprinting, etching, electrochemical corrosion, and the like.

In some implementations of this application, before step S02 is performed, performing surface processing on the silicon substrate having the first blind hole is also included. A surface processing method includes but is not limited to first cleaning with at least one of organic solvents such as acetone, ethanol, and isopropanol, and then cleaning with hydrofluoric acid, an aqueous solution of hydrofluoric acid and hydrochloric acid, or a Piranha solution, and finally rinsing with deionized water and drying.

In some implementations of this application, in step S02, the epitaxial layer is grown by using a vapor phase epitaxy process.

In some implementations of this application, in step S02, growing the epitaxial layer on the first surface includes: growing a two-dimensional nucleation layer on the first surface.

In some specific embodiments, in this case, growing the two-dimensional nucleation layer on the first surface includes: placing the silicon substrate in the reaction chamber, introducing a growth raw material required for growing the two-dimensional nucleation layer into the reaction chamber, and controlling a molar ratio of a group V element to a group III element in the growth raw material to be 1:(20-100), a growth temperature to be from 900°C to 1200°C, and a growth pressure (a pressure in the reaction chamber) to be from 50 mbar to 100 mbar. In this way, atoms can be induced to laterally migrate, which induces the atoms to laterally grow. This facilitates preparation of the two-dimensional nucleation layer, reduces a density of a nucleation island of the two-dimensional nucleation layer, and increases a size of the nucleation island, thereby reducing a dislocation density introduced by inter-island coalescence at an early stage of growth of the two-dimensional nucleation layer, and helping improve crystal quality of the two-dimensional nucleation layer. Specifically, the molar ratio of the group V element (for example, an N element) to the group III element (for example, an Al element) in the growth raw material may be but is not limited to 1:20, 1:30, 1:40, 1:50, 1:60, 1:70, 1:80, 1:90, 1:95, or 1:98. The growth temperature of the two-dimensional nucleation layer may be but is not limited to 900°C, 920°C, 950°C, 980°C, 1000°C, 1020°C, 1050°C, 1080°C, 1100°C, 1120°C, 1150°C, 1180°C, 1200°C, or the like. The growth pressure of the two-dimensional nucleation layer may be but is not limited to 5 mbar, 60 mbar, 80 mbar, 100 mbar, or the like. In some specific embodiments of this application, the density of the nucleation island is from 10¹⁰ cm² to 5x10¹⁰ cm², and the size of the nucleation island is from 10 nm to 50 nm. Specifically, in the foregoing steps, growth of the two-dimensional nucleation layer is interrupted, and the density of the nucleation island and the size of the nucleation island are tested by using an SEM or an AFM.

In some implementations of this application, in step S02, growing the epitaxial layer on the first surface includes: sequentially growing the two-dimensional nucleation layer and a three-dimensional nucleation layer on the first surface. In some specific embodiments, after the two-dimensional growth layer is prepared, a temperature and the pressure in the reaction chamber are changed, and the growth raw material is adjusted to grow the three-dimensional nucleation layer. A growth temperature of the three-dimensional nucleation layer is from 900°C to 1100°C, a growth pressure is from 100 mbar to 300 mbar, and a molar ratio of a group V element to a group III element in the growth raw material is 1:(100-2000). In this way, the atoms can be induced to both laterally and vertically grow, which improves a growth rate of the nucleation layer, and further improves production efficiency of the epitaxial wafer.

Specifically, the molar ratio of the group V element (for example, an N element) to the group III element (for example, an Al element) in the growth raw material on the three-dimensional nucleation layer may be but is not limited to 1:120, 1:150, 1:180, 1:200, 1:250, 1:300, 1:350, 1:400, 1:500, 1:600, 1:700, 1:800, 1:900, 1:1000, 1:1200, 1:1500, or 1:1800. The growth temperature of the three-dimensional nucleation layer may be but is not limited to 900°C, 920°C, 950°C, 980°C, 1000°C, 1020°C, 1050°C, 1080°C, 1100°C, or the like. The growth pressure of the three-dimensional nucleation layer may be but is not limited to 100 mbar, 120 mbar, 150 mbar, 180 mbar, 200 mbar, 220 mbar, 250 mbar, 280 mbar, 300 mbar, or the like.

In the foregoing steps, the foregoing growth raw material may be selected from materials well known to a person skilled in the art based on a composition of the nucleation layer, provided that the nucleation layer can be smoothly grown. When the nucleation layer is an AlN layer, the growth raw material includes an aluminum element source and a nitrogen element source. The aluminum element source includes but is not limited to trimethyl aluminum, and the nitrogen element source includes but is not limited to ammonia.

In some implementations of this application, step S02 further includes: sequentially growing a stress regulation layer, a high-resistance buffer layer, a channel layer, an insertion layer, a barrier layer, and a cap layer on a surface that is of the nucleation layer and that is away from the silicon substrate layer.

In step S02, when the stress regulation layer, the high-resistance buffer layer, the channel layer, the insertion layer, the barrier layer, and the cap layer are grown, a growth raw material and a process parameter control required for each may be any growth raw materials and process parameters that are well known in the art. A person skilled in the art may select and adjust the growth materials and process parameters based on an application requirement.

With reference to FIG. 6, embodiments of this application further provide a radio frequency device 1, including a drain 2, a source 3, a gate 4, and the epitaxial wafer 100 according to embodiments of this application. The drain 2, the source 3, and the gate 4 are disposed on a surface that is of the epitaxial layer 20 and that is away from the silicon substrate layer 10, and the drain 2 and the source 3 are respectively disposed on two opposite sides of the gate 4 and are isolated from each other. By adopting the epitaxial wafer 100 provided in embodiments of this application, the radio frequency device 1 has a low radio frequency loss, low production costs, and can be prepared into a large size, and therefore has strong market competitiveness. In some specific implementations, the radio frequency device 1 is a power amplifier.

In some implementations of this application, the drain 2 is in contact with the cap layer 207, the source 3 is in contact with the cap layer 207, the source 3 is in ohmic contact with the cap layer 207, and the drain 2 is in ohmic contact with the cap layer 207. A material of the source 3 and that of the drain 2 may be a Ti layer, an Al layer, a Ni layer, and an Au layer that are sequentially stacked.

In some implementations of this application, the radio frequency device 1 further includes a passivation layer 6. The passivation layer 6 is disposed on the surface that is of the epitaxial layer 201 and that is away from the silicon substrate layer 10. A plurality of opening portions are provided on the passivation layer 6. The drain 2, the source 3, and the gate 4 are respectively located in the plurality of opening portions. The passivation layer 6 may suppress trapping effect of a surface state, to improve performance of the radio frequency device 1. In embodiments of this application, a material of the passivation layer 6 is not limited, and a person skilled in the art may select a material based on an actual requirement, for example, SiO₂ and SiNx.

In some implementations of this application, an interconnect metal 5 is disposed on all surfaces that are of the source 3, the drain 2, and the gate 4 and that are away from the epitaxial wafer 100, and the interconnect metal 5 is exposed from the passivation layer 6. A single radio frequency device 1 may have a plurality of repeat units or circuit elements, and the interconnect metal 5 is configured to connect different repeat units or circuit elements, transfer an electronic signal, and supply power to the different repeat units or circuit elements. A material of the interconnect metal 5 may be a conductive metal commonly used in the art, for example, copper and gold.

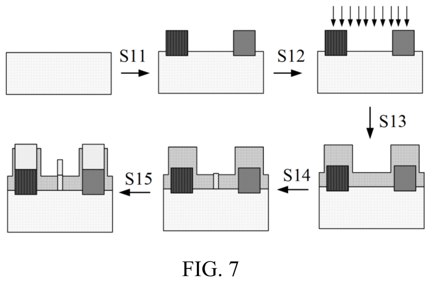

In some implementations of this application, with reference to FIG. 7, preparation of the radio frequency device 1 may include the following steps.

S11: Prepare ohmic contact on a surface that is of the epitaxial wafer 100 and that is away from the silicon substrate layer 10, to obtain the drain 2 and the source 3.

S12: Considering that a plurality of sets of radio frequency devices 1 may be simultaneously prepared on one epitaxial wafer 100, perform insulation isolation on different regions, to avoid mutual impact between the plurality of devices.

S13: Prepare the passivation layer 6, and perform hole opening processing.

S14: Perform gate groove etching and gate preparation.

In some implementations of this application, the method further includes S15: separately forming the interconnect metal 5 on the surfaces that are of the source 3, the drain 2, and the gate 4 and that are away from the epitaxial wafer 100.

In some implementations of this application, at least one first blind hole is included between an orthographic projection of the drain 2 on the silicon substrate layer 10 and an orthographic projection of the gate 4 on the silicon substrate layer 10. In this way, one repeat unit of the radio frequency device 1 includes at least one air gap, to ensure that a radio frequency loss of any repeat unit can be effectively suppressed, thereby greatly reducing the radio frequency loss of the radio frequency device. The air gap may be formed by the first blind hole, or may be jointly formed by the first blind hole and the second blind hole.

In some specific implementations of this application, the foregoing effect may be implemented by adjusting and controlling an arrangement pitch of the first blind holes (that is, an arrangement pitch of the air gaps) and a distance between the source and the drain. Specifically, if the arrangement pitch of the first blind holes is a, the distance between the source and the drain is b, and an opening diameter of the first blind hole is c, a, b, and c satisfy b≥a+2c, where a, b, and c are counted in a same unit. In some specific embodiments, the distance b between the source and the drain is from 1 µm to 3 µm. This makes preparation easy, and also helps ensure performance of the radio frequency device.

Embodiments of this application further provide a terminal radio frequency module, including the radio frequency device provided in embodiments of this application and an antenna. The radio frequency device is configured to amplify a radio frequency signal and output an amplified radio frequency signal to the antenna for radiation to the outside.

In some specific embodiments, the terminal radio frequency module is a 5G radio frequency module.

Embodiments of this application further provide a terminal device, including the terminal radio frequency module provided in embodiments of this application. Because the terminal radio frequency module provided in embodiments of this application is included, the terminal device has strong market competitiveness. In some specific embodiments, the terminal device includes but is not limited to a mobile phone.

In this application, "-" indicates a range value, including endpoint values at two ends. For example, a value of a may be 0.5-15, which indicates that the value of a may range from 0.5 to 15, and endpoint values 0.5 and 15 are included.

## Claims

1. An epitaxial wafer, comprising a silicon substrate layer and an epitaxial layer that are stacked, wherein the epitaxial layer comprises a nucleation layer stacked on a surface of the silicon substrate;
a surface that is of the silicon substrate layer and that is close to the nucleation layer has a plurality of first blind holes, a surface that is of the nucleation layer and that is close to the silicon substrate layer has a plurality of second blind holes, any one of the second blind holes is provided corresponding to one first blind hole, and an orthographic projection of the second blind hole on the silicon substrate layer overlaps the corresponding first blind hole; and
a depth of the first blind hole is greater than or equal to 200 nm.

2. The epitaxial wafer according to claim 1, wherein the depth of the first blind hole is from 200 nm to 500 nm.

3. The epitaxial wafer according to claim 1 or 2, wherein a quantity of the second blind holes is the same as a quantity of the first blind holes, and the plurality of first blind holes are provided in a one-to-one correspondence with the plurality of second blind holes.

4. The epitaxial wafer according to any one of claims 1 to 3, wherein a depth of the second blind hole is from 300 nm to 500 nm.

5. The epitaxial wafer according to any one of claims 1 to 4, wherein an inner diameter of the first blind hole is equal everywhere in a stacking direction of the silicon substrate layer and the epitaxial layer.

6. The epitaxial wafer according to any one of claims 1 to 5, wherein an included angle between a side wall of the first blind hole and the surface that is of the silicon substrate layer and that is close to the nucleation layer is from 85° to 90°.

7. The epitaxial wafer according to any one of claims 1 to 6, wherein an opening diameter of the first blind hole is from 100 nm to 1000 nm.

8. The epitaxial wafer according to any one of claims 1 to 7, wherein an opening shape of the first blind hole is a circle or an n-sided polygon, and n>8.

9. The epitaxial wafer according to any one of claims 1 to 8, wherein the plurality of first blind holes are periodically arranged in a first direction, and the first direction is perpendicular to a stacking direction of the silicon substrate layer and the nucleation layer; and
in the first direction, a minimum distance between openings of two adjacent first blind holes on the silicon substrate layer is from 200 nm to 1000 nm.

10. The epitaxial wafer according to claim 9, wherein the plurality of first blind holes are periodically arranged in a regular hexagon in the first direction.

11. The epitaxial wafer according to any one of claims 1 to 10, wherein the nucleation layer is a two-dimensional nucleation layer.

12. The epitaxial wafer according to claim 11, wherein a thickness of the nucleation layer is from 300 nm to 1000 nm.

13. The epitaxial wafer according to any one of claims 1 to 10, wherein the nucleation layer comprises a two-dimensional nucleation layer and a three-dimensional nucleation layer that are sequentially stacked, and the two-dimensional nucleation layer is disposed close to the silicon substrate layer.

14. The epitaxial wafer according to claim 13, wherein a thickness of the two-dimensional nucleation layer is from 300 nm to 500 nm, and a thickness of the three-dimensional nucleation layer is from 200 nm to 500 nm.

15. The epitaxial wafer according to any one of claims 1 to 14, wherein the nucleation layer is an aluminum nitride layer.

16. The epitaxial wafer according to any one of claims 11 to 15, wherein a dislocation density of the two-dimensional nucleation layer is less than 5×10⁹/cm², and surface roughness of the two-dimensional nucleation layer is less than 0.5 nm.

17. The epitaxial wafer according to any one of claims 11 to 16, wherein a molar ratio of a group V element to a group III element on the two-dimensional nucleation layer is 1:(20-100).

18. The epitaxial wafer according to claim 13 or 14, wherein a molar ratio of a group V element to a group III element on the three-dimensional nucleation layer is 1:(100-2000).

19. The epitaxial wafer according to any one of claims 1 to 18, wherein the epitaxial layer further comprises a stress regulation layer, a high-resistance buffer layer, a channel layer, an insertion layer, a barrier layer, and a cap layer that are sequentially stacked; and
the stress regulation layer is disposed on a surface that is of the nucleation layer and that is away from the silicon substrate layer.

20. The epitaxial wafer according to any one of claims 1 to 19, wherein a room-temperature resistivity of the silicon substrate layer is greater than or equal to 2000 Ω·cm.

21. A preparation method for the epitaxial wafer according to any one of claims 1 to 20, comprising:
providing a silicon substrate, and forming the plurality of first blind holes on one side surface of the silicon substrate to obtain the silicon substrate layer; and
growing the epitaxial layer on the surface that is of the silicon substrate layer and that has the first blind holes, wherein the epitaxial layer comprises the nucleation layer.

22. The preparation method according to claim 21, wherein growing the nucleation layer on the surface that is of the silicon substrate layer and that has the first blind holes comprises:
growing the two-dimensional nucleation layer on the surface that is of the silicon substrate layer and that has the first blind holes, wherein a growth temperature of the two-dimensional nucleation layer is from 1000°C to 1200°C, a growth pressure is from 50 mbar to 100 mbar, and a molar ratio of a group V element to a group III element in a growth raw material is 1:(20-100).

23. The preparation method according to claim 22, further comprising: growing the three-dimensional nucleation layer on a side surface that is of the two-dimensional nucleation layer and that is away from the silicon substrate layer, wherein a growth temperature of the three-dimensional nucleation layer is from 900°C to 1100°C, a growth pressure is from 100 mbar to 300 mbar, and a molar ratio of a group V element to a group III element in a growth raw material is 1:(100-2000).

24. A radio frequency device, comprising a drain, a source, a gate, and the epitaxial wafer according to any one of claims 1 to 20, wherein the drain, the source, and the gate are disposed on a surface that is of the epitaxial layer and that is away from the silicon substrate layer, and the drain and the source are respectively disposed on two opposite sides of the gate and are isolated from each other.

25. The radio frequency device according to claim 24, wherein at least one first blind hole is comprised between an orthographic projection of the drain on the silicon substrate layer and an orthographic projection of the gate on the silicon substrate layer.

26. A terminal radio frequency module, comprising the radio frequency device according to claim 24 or 25 and an antenna, wherein the radio frequency device is configured to amplify a radio frequency signal and output an amplified radio frequency signal to the antenna for radiation to the outside.

27. A terminal device, comprising the terminal radio frequency module according to claim 26.
